Europäisches Patentamt

European Patent Office

Office européen des brevets

(19)

(11) Publication number: 0 312 802
A2

# (12) EUROPEAN PATENT APPLICATION

(21) Application number: 88115768.9

(51) Int. Cl.⁴: H01L 21/48

(22) Date of filing: 24.09.88

(30) Priority: 24.09.87 US 100809
09.08.88 US 230659

(43) Date of publication of application:
26.04.89 Bulletin 89/17

(84) Designated Contracting States:
CH DE FR GB IT LI

(71) Applicant: ELASTOMERIC TECHNOLOGIES,
INC.
ETI 2940 Turnpike Drive
Hatboro, PA 19040(US)

(72) Inventor: Buchoff,Leonard S.Dr. Elastomeric
Techn. Inc.
2940 Turnpike Drive
Hatboro, PA 19040(US)

(74) Representative: Königseder, geb. Egerer,
Claudia
Zugspitzstrasse 65
D-8104 Grainau(DE)

(54) Self-mounted chip carrier.

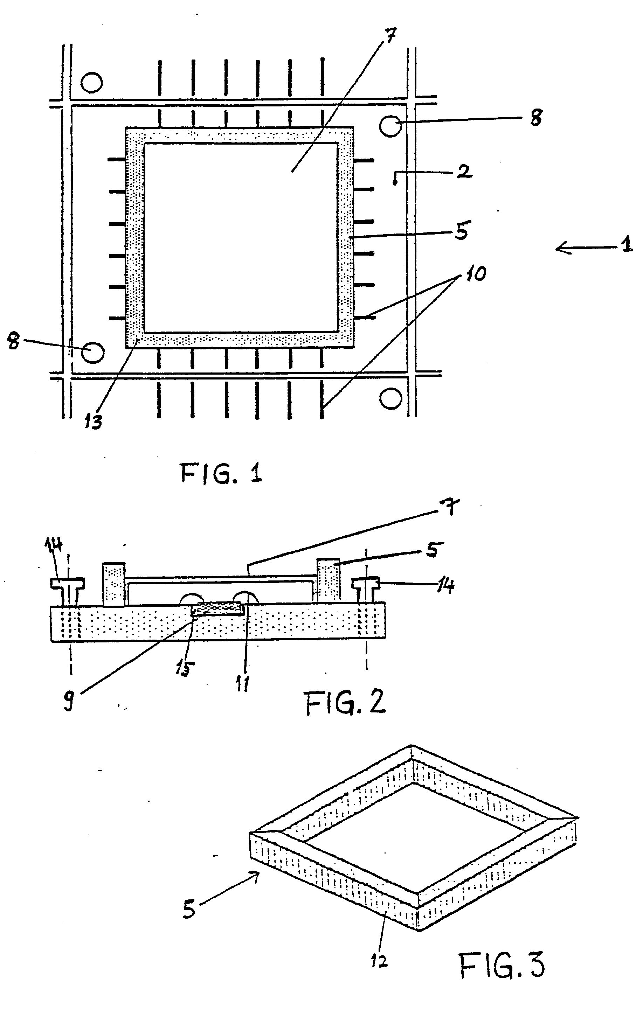

(57) The invention relates to a self-mounted chip carrier (1) with means for positioning and clamping to a circuit. Said chip carrier (1) comprises a surface in a cut-out portion (15) provided with an integrated circuit (9) and registration means (8, 14) for securing said carrier to a mating substrate and for aligning the contact pads 10 on the chip carrier with mating pads on the substrate, and a connector ring (5) between carrier (1) and substrate (2) made from elastomeric material. (Fig. 1 and 2).

FIG. 2

FIG. 1

## SELF-MOUNTED CHIP CARRIER

The invention relates to circuitry attachment devices, and more particularly to an integrated circuit attachment apparatus and method comprising a self-mounted chip carrier with a means for positioning and clamping to a circuit and an elastomeric connector element seated on a chip carrier.

In order to replace defective unit or recover an expensive component from an other wise operable circuit, it is desirable to easily insert and remove various units from a circuit board. Expensive and space consuming sockets which usually require plated through holes are often used to facilitate location and removal of particular components. On current chip carriers, having approximately 1,25 mm centers tolerances on the carrier and socket are sufficient to accommodate socketing. On the integrated circuit carriers (chip carriers) with leads on 0,75 mm centers, there are few sockets on the market which can satisfactorily perform such location and removal of components. These sockets require very tight tolerance carriers and must sometimes be optically aligned. Unfortunately, it is very difficult to obtain sockets which will contact high density circuits and many new circuits today are surface mounted and have no plated through holes to accept normally leaded devices. The current technology maintains the integrated circuits on chips on substrates of either ceramic, laminate or plastic and solders these carriers to the circuit boards directly or through resilient leads. As board spacing becomes closer, e.g., less than 1,25 mm on centers of the contacts, soldering components become difficult as individual leads become misaligned and solder bridging becomes a serious problem. Also, the heat of soldering can ruin temperature sensitive parts on printed circuit boards. As board spacing is being reduced to 0,75 mm centers and chip carriers with centers of 0,37 mm are in the design stages, the soldering problem becomes more acute and must be addressed to maintain pace with the increasing efficiency of the electronic industry. Because of these and other problems associated with the prior art, it is an object of the inventive chip carrier to provide a device requiring minimal board space. Another object of the invention is to accommodate chip carrier contact spacing closer than on 0,75 mm centers.

A further object of the invention is to provide a chip carrier with ease of field replacement at a low cost. Additionally, an object of the invention is the ability to manufacture and test such chip carriers automatically. These and other objects are achieved by the self-mounted chip carrier as set forth in the appended claims.

The self-mounted chip carrier of the invention comprises a contact pad metallized chip carrier substrate which contains the integrated circuit and registration holes located in diametrically opposed corners of the substrate for aligning and securing the carrier to the circuit board. The invention differs from prior art chip carriers by employing a compliant, elastomeric (connector element) ring. This ring could be made of "STAX", "MOE", or "Matrix MOE", and positioned between the carrier and the circuit board to act as an intermediary for making contact between contact areas on the chip carrier and on the circuit board. In addition to the use of the STAX or MOE ring, individual linear elements can also be used in configuration with the self-mounted chip carrier.

A prime advantage of the invention is that despite its unique capabilities, the cost of the units described are comparable to present chip carriers and are significantly less expensive than a chip carrier plus holder, because the expense of the socket is eliminated. Furthermore,these units occupy minimal board area and have a very low profile as the large socket is absent. Also, leads on centers as close as 250 $\mu$m may be reliably handled, and heat sinking could be incorporated into the package easily.

Other attributes of the self-mounted chip carrier include automatic production, low cost, excellent high fre quency performance, ease of field replacement, and the possibility of automatic assembly.

Automatic production is facilitated by the potential of sequentially performing the manufacturing step while the chip carriers are in a precise array on a monolithic substrate. Also, the lead attachment operation required by other technologies is absent. Gang testing of the populated carriers contributes most to the feasibility of automatic production. Cost is reduced by eliminating the expense of a separate socket and the time and expense of the socket attachment operation.

Excellent high frequency operation results from the very short connection path, low capacitance and low inductance. These produce shorter time delays and a minimum of signal distortion in the gigahertz frequency range.

Field replacement is facilitated by the alignment holes which aid the accurate installation of the self-mounting chip carrier with a minimum of skill and specialized tools. Also, the elastomeric connecting elements are preassembled onto the carrier with only pressure needed to affect reassembly. Leads are not unsoldered and resoldered as they are with some competing technologies.

Automatic assembly of the chip carriers onto printed wiring boards by automatic insertion equipment is facilitated by the alignment holes and pre-assembled elastomeric elements. Simply applying a clamping force completes the assembly operation.

The self-mounted chip carriers may be made and tested in a highly automated way. By this procedure, the chip carrier bodies are formed in a ceramic or plastic matrix similar to the standard way of producing ceramic chip carriers. The advantage lies in the ability to install the chips in the carriers while still in the matrix,and to attach the protective covers and test rapidly and economically using the elastomeric elements to contact the test interface.

Figure 1 is a plan view of the self-mounted chip carrier.

Figure 2 is a cross sectional view of the self-mounted chip carrier of Fig. 1.

Figure 3 is a perspective view of an MOE or STAX ring onto which the MOE or STAX ring is placed.

Figure 4A is a plan view of various matrices of substrates.

Figure 4B is an enlarged plan view of a sample substrate.

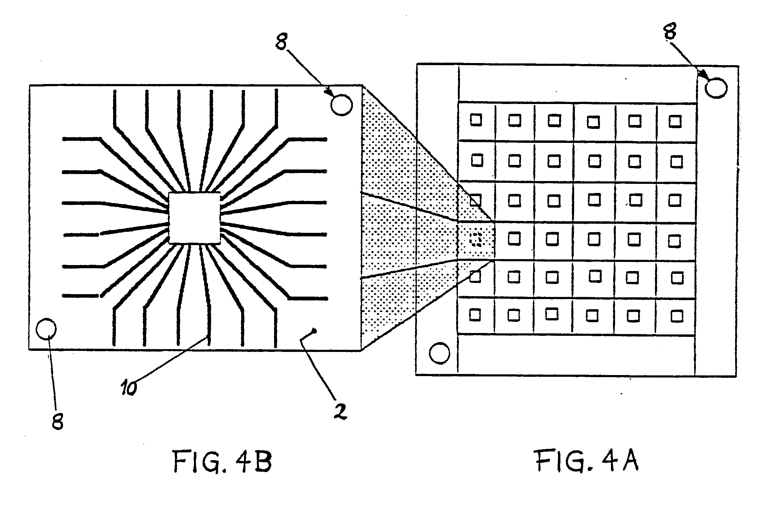

In the drawings, like numerals indicate identical parts throughout the several views. Electronic carrier and self-mounted chip carrier 1 is generally shown, comprising rectangular substrate surface 2 with contacts 10 on the surface. Contact pads 10 comprise individual grid lines which are aligned in two directions generally perpendicular to each other, although other configurations, as shown in Fig. 4B, may be used. Substrate surface 2 further comprises registration holes 8 located at diametrically opposed corners of substrate 2 for proper alignment and securing of the carrier to substrate surface 2. These registration holes 8 may be located in different positions other than as shown in Fig. 1. Shouldered bolts 14, inserted into registration holes 8, are used for proper alignment of substrate 2.

In one way of mass producing the carriers substrate 2 sits in an array of substrates, as shown in Fig. 4A. The substrate 2 of the self-mounted chip carrier 1 can be made from a ceramic, laminate, molded plastic or other suitable material. The conductive pads 10 on the substrate 2 are applied by thick film screening, thin film techniques, additive plating, or subtractive methods and would be accurately positioned by the registration holes 8 at its diametrically opposed ends. A hold-down mechanism, such as the shouldered screws 14, apply the pressure required to mate the carrier 1 to the board 20 (not shown). The screws 14 may operate in conjunction with an elastic or spring member (not shown) which helps distribute the load on the carrier substrate 2. This hold-down mechanism may be inte grated into the heat sink structure. This would be done by attaching the hold-down screws to the heat sink. Thus, the heat sink would be mounted onto the chip carrier in the normal way, but the attached screws would fit into the alignment holes. The heat sink body would distribute the hold-down load over the chip carrier surface 2.

The chip carrier body has features on it which facilitate aligning contacts 10 on the chip carrier 1 with traces on the electronic circuit, e.g., printed wiring board, hybrid or Multiwire. Examples of these features are holes to match posts on the circuit or posts to match holes. These features can be part of the main body 2 of the chip carrier 1 or another attached member.

Various means are provided to hold an elastomeric element 5 onto the chip carrier 1 to provide connection between the chip carrier pads 10 and matching pads (not shown) on the circuit. These means include having an extended area (not shown) of the chip carrier 1 to serve as a holder, or soldering MOE ring 5 to the carrier pads 10,or the elements can simply be adhesively attached.

An elastomeric connector ring 5 (MOE, Matrix MOE or STAX ring) generally comprises various metallic particles or complete wires 13 embedded into the parallel horizontal layers 12 of the elastomeric material or flat wires on the elastomer surface. The elastomeric ring 5 generally circumscribes a lid 7 which serves as a stop to prevent deflection of ring 5 and to protect a chip 9 (integrated circuit).

The chip 9 rests in a cut portion 15 on the carrier 1. Wires 11 project up and outwardly from chip 9 to contact contact pads 10 on the surface of substrate 2. In another embodiment of the invention, a heat sink could be attached directly to the package,and holes drilled through the heat sink would serve as the positioning holes.

## Claims

1. A self-mounted chip carrier (1) comprising a surface (2) containing the integrated circuit; registration means for securing said carrier (1) to a mating substrate and for aligning a mating pad on the chip carrier (1) with a mating pad on the substrate; and a complaint connector between the carrier and the substrate.

2. The self-mounted chip carrier of claim 1, characterized in that said connector is made from an elastomeric material.

3. The self-mounted chip carrier of claim 2, characterized in that said surface (2) has a contact pad metallized area.

4. The self-mounted chip carrier of claim 3, characterized in that said registration means are located away from the contact pad metallized area.

5. The self-mounted chip carrier of claim 4, characterized in that it further comprises a lid (7).

6. The self-mounted chip carrier of claim 5, characterized in that said lid (7) also serves as a deflection stop.

7. The self-mounted chip carrier of claim 6, characterized in that said registration means comprise bolt members (14).

8. The self-mounted chip carrier of claim 7, characterized in that said bolt members (14) are shouldered.

9. The self-mounted chip carrier of claim 8, characterized in that said bolt members (14) are located in diametrically opposed corners of said surface (2).

10. The self-mounted chip carrier of claim 9, characterized in that said means for securing is a shouldered screw.

11. The self-mounted chip carrier of claims 1 and 2, characterized in that said connector is a metal-on-elastomer ring (5).

12. The self-mounted chip carrier of claim 11, characterized in that said metal-on-elastomer ring (5) is configured in a matrix formation.

13. The self-mounted chip carrier of claim 10, characterized in that said connector (5) comprises a plurality of linear strips.

14. The self-mounted chip carrier of claim 10, characterized in that said connector (5) is compliant.

15. The self-mounted chip carrier of claim 14, characterized in that said connector (5) is metallic.

16. The self-mounted chip carrier of claim 15, characterized in that said connector is adapted to fit into spaces in a molded ring.

17. A self-mounted chip carrier (1) comprising a contact pad metallized substrate containing the integrated circuit; registration holes (8) on diametrically opposed ends of the substrate; shouldered bolt members (14), adapted to fit into said holes (8), for aligning and securing the carrier to the substrate (2); a compliant elastomeric metal-on-elastomer ring (5) configured in a matrix formation, wherein said ring contacts said contact pad; and a lid (7) to retain said chip in position and to decrease deflection of said MOE ring.

FIG. 1

FIG. 2

FIG. 3

FIG. 4B

FIG. 4A